# EUROPEAN PATENT SPECIFICATION

(11) **EP 0 475 596 B1**
(45) Date of publication and mention of the grant of the patent: **18.10.1995**
(21) Application number: 91307501.6
(22) Date of filing: 14.08.1991
(51) Int. Cl.: C23G 5/024, C11D 7/50

(54) **Methods for cleaning articles**
Verfahren zur Reinigung von Artikeln
Méthodes pour nettoyer des articles

(30) Priority: 14.08.1990 GB 9017841
(43) Date of publication of application: 18.03.1992
(73) Proprietor: Union Camp Corporation, Wayne New Jersey 07470 - 2066 (US)
(72) Inventor: Ferber, G.J., Cuddington, Northwich, Cheshire (GB)
(74) Representative: Lawrence, Peter Robin Broughton

(56) References cited:
- EP-A- 0 194 589
- EP-A- 0 416 763
- WO-A-87/00209
- PATENT ABSTRACTS OF JAPAN, vol. 13, no. 428 (P-936), 25 September 1989; & JP-A-1 161 349
- PATENT ABSTRACTS OF JAPAN, vol. 13, no. 255 (C-606), 13 June 1989; & JP-A-10 56 798

## Description

### Background of the Invention

This invention relates to the cleaning of dirty articles. Such articles may be, for instance, relatively small metal, ceramic or glass articles, for instance circuit boards or machined parts.

It is routine practice to clean dirty surfaces by contacting them with an aqueous or non-aqueous liquid, and to promote the contact by forcing the liquid against the surfaces. Thus surfaces can be cleaned by water, often brushed on or applied as a jet, and then left to dry. Water is not very effective for removing organic residues but steaming is sometimes used.

Aqueous detergent compositions may remove organic residues but are liable to leave residues of detergents, necessitating thorough rinsing to remove these residues.

The most effective way of removing organic dirt from articles is therefore generally recognised as involving contacting the articles with organic solvents that will dissolve the residues. As a result there is extremely large capital investment in equipment for cleaning articles by contacting the articles with an organic solvent while the articles are held within a vessel. The contact can be by immersing the articles in liquid phase solvent or by exposing them to vapour phase solvent, generally at a relatively cool temperature such that the solvent condenses on to the articles.

The chosen solvent must have adequate solvency power for the residues that are to be removed, it must have a flash point sufficiently above the temperature of use that it is safe to use, and it preferably has a volatility such that it does not leave a residual film of solvent after use. Preferably therefore the solvent will evaporate relatively quickly when exposed to the ambient atmospheric temperature of, for instance, 30°C or below.

Low boiling hydrocarbons often have adequate solvency power and may be adequately volatile, but they suffer from the disadvantage that they have low flash point. Higher boiling hydrocarbons may have adequate solvency power and a reasonably safe flash point, but their volatility is sufficiently low that residues of them remain on the articles unless the articles are deliberately heated, but this is undesirable because of the risk of the temperature then approaching or exceeding the flash point.

Because of these difficulties, halogenated solvents have become widely accepted as cleaners that have suitable solvency power, adequately high flash point and suitable volatility at safe temperatures. Examples are chlorocarbons, fluorocarbons and chlorofluorocarbons, the compounds generally containing below 4 carbon atoms, often 1 or 2 carbon atoms.

Accordingly industry has made vast investment in apparatus for cleaning hard surfaces such as circuit boards and soft surfaces such as fabrics with such solvents. Possible environmental disadvantages of the use of such solvents is widely recognised. A very large number of alternative solvents have therefore been investigated, especially in recent years, but none of them have yet proved to be commercially as convenient to operate as the halocarbons which they are intended to replace.

There is therefore an acute need for achieving satisfactory cleaning of articles using a solvent having good solvency power and which is preferably not a volatile halogenated hydrocarbon in such a way that there are substantially no solvent residues on the article and the operatives are not exposed to a flash hazard. Preferably this objective would be achieved with little or no modification of the existing apparatus that is designed for use with, for instance, chlorofluorocarbons.

Amongst the solvents that have been investigated are terpene solvents. Such solvents have been known for a very long time, for instance we are aware that some terpene solvents were commercially available by the early 1940's at least, and possibly earlier. However they have never proved to be of widespread commercial value and part of the problem seems to be that their use resulted in contamination of the article with residues of the terpene solvent, and this contamination rendered the article unacceptable. Also the terpenes are liable to be contaminated, or to form, resinous products and such residues can be difficult to remove.

JP-A-1161349 discloses a cleaning fluid for printing plates containing specific alkyl benzenes including cymene derivatives.

JP-A-1056798 discloses liquid detergent/bleaches in which the smell of chlorine bleach is masked using a perfume in an amount up to 1% by weight in the composition. The perfume may comprise para-menthane.

In EP-A-0416763, unpublished at the priority date of the present claims, a process of cleaning a dirty article using a cleaning solvent comprising terpenes is disclosed. No mention is made of any kind of terpene analogue such as required by the present claims.

### Objects of the Invention

The purpose behind the invention therefore is to meet the acute need to provide a method of cleaning dirty articles, which method is environmentally acceptable and that provides articles having a cleanliness that can meet the highest standards, for instance the standards of the electronics industry.

### Summary of the Invention

In the invention, a dirty article is cleaned by contact with a solvent that comprise a hydrogenated or dehydrogenated analogue of a terpene compound. Although such compounds can be made synthetically stating from, for instance, petrochemicals, the preferred solvents are made by hydrogenation or dehydrogenation of components of terpenes derived from, for instance, wood and other vegetable products such as turpentine. For convenience, these analgoues and derivatives are referred to below as "terpene solvents" even though they do not contain terpene.

According to the invention a dirty article is contacted with a terpene solvent under conditions that result in cleaning of dirt from the article and in solvent contamination of the article by the terpene solvent, and in this process the solvent contamination is removed by contacting the contaminated article at a temperature of at least 60°C with an aqueous medium and evaporating the solvent contamination from the surface to produce a distillate comprising solvent and aqueous medium. Preferably the evaporation is by formation of an azeotrope.

### Description of the Preferred Embodiments

By the invention it is possible to obtain articles having the highest standards of cleanliness but in a manner that is highly desirable from the environmental point of view. The solvent and water can both be recycled and vapour emissions can be reduced to satisfactorily low values.

The flash point (closed cup) of the terpene solvent is usually below 150°C and often below 125°C. The solvent can be a mixture and generally most or all of the solvent in the mixture has a flash point below 100°C.

The boiling point of the terpene solvent (which may be a mixture) is generally above 70°C and most usually above 100°C, generally above 130°C. Since the solvent is often a mixture, it will often boil over a range of temperatures, and the boiling point quoted above is the bottom of this range. Generally the boiling point is below 250°C (i.e., the top of the boiling range should be below 250°C). Solvents that boil at temperatures somewhere within the range 150 to 200°C are often preferred.

The invention can also be applied with other methods of removing the residual solvent contamination. For instance the article after cleaning with the defined terpene type solvent can be immersed in or sprayed with a medium consisting of the low boiling solvent at low or high temperatures or may be washed with an aqeuous solution of a surfactant, preferably a volatile surfactant. Alternatively, washing in cold or warm water can be useful.

The terpene analogues to which the present invention relates include cymenes, menthenes and menthanes, often as the para isomer. A preferred solvent comprises para cymene.

An advantage of the invention is that it provides the advantage of terpene solvents as regards cleansing power and environmental factors while avoiding any risk of the formation of polymerisation products during use.

The analogues can be blended with other materials, provide such other materials do not destroy the advantages that are gained by use of the analogues. Generally at least 50% of the solvent is selected from cymene, menthene and/or menthane. Particularly preferred are novel compositions comprising 50-90% para or other menthenes, 2-20% para or other cymene, 0-40% para or other menthadienes and 0-20% para or other menthanes. The combination of at least 50% para menthane with a lesser amount para cymene is particularly valuable, as are blends of such solvents with terpene alcohols. Meta can be used in place of para.

In one aspect of the invention, the solvent contamination that remains after the terpene cleaning stage is removed azeotropically by forming an azeotrope with an aqueous medium. The azeotrope-forming capabilities of terpene solvents are particularly advantageous, and this constitutes another reason why the terpene solvents are particularly preferred in the invention.

Although adequate results are often achieved as a result of the formation of an azeotrope between the solvent and the water, azeotroping can be promoted, and in particular the azeotroping temperature can be reduced, by including a suitable tertiary solvent. Additionally, the removal of the solvent contamination is promoted if the contamination is spread as a thin film over the article, rather than being concentrated in droplets, and so the presence of a depressant for surface tension is beneficial. Many tertiary solvents that promote the formation of an azeotrope will also help film formation.

These additional solvents should be low boiling solvents so that they are more volatile than the terpene or other main solvent. In general, they should boil at a temperature below the azeotroping temperature, so as to ensure that none of the tertiary solvent remains as a residual contamination. Generally they boil at below 100°C. Various aliphatic compounds such as ketones or, preferably, amines, ethers or alcohols may be used. The total number of carbon atoms in such materials is generally below 8 and preferably each aliphatic group in such compounds contains less than 8, usually 2 to 4, carbon atoms. Particularly preferred materials are propanols and butanols such as isobutanol or, preferably, isopropanol.

Instead of or in addition to including such low boiling solvents to promote film formation, it is also possible to include a surfactant. This should preferably be a volatile surfactant and in particular it should be azeotropicallly volatile.

These additives may be included in the terpene solvent with which the dirty article is initially contacted, and may thus promote the cleaning of the article, typically in an amount of below 10% by weight of the total terpene solvent composition. In other methods, however, the aqueous medium contains the low boiling solvent or other additive. Thus the aqueous medium can consist of water or a mixture of water and the low boiling solvent. The ratio low boiling solvent:water can be from 1:50 to 10:1, generally 1:20 to 1:1.

Although some low boiling, and usually water miscible, organic solvent can be included in the terpene or other cleaning solvent, generally substantially all of this cleaning solvent is immiscible with water. From the environmental and economic point of view, an important feature of the invention is that the azeotrope that is formed between the terpene or other cleaning solvent and the water is condensed and is allowed to phase separate, and the terpene solvent phase is separated and is recycled for subsequent use in cleaning of dirty articles.

The azeotrope is therefore preferably formed by evaporation of the azeotropic mixture (generally at a temperature below 100°C) in a vessel that contains the aqueous medium in its base and that has an outlet for evaporated azeotrope and a condenser across the outlet on which the azeotrope is condensed.

The process is preferably conducted in multi-stage apparatus comprising one or more solvent-cleaning tank and one or more rinsing tanks inlcuding at least one azeotroping tank that has an outlet for volatile gases across which there is a condenser, including means for recovering condensate from the surfaces of the condenser. A solvent cleaning tank is, preferably, an immersion tank, i.e. it is designed for immersion of the dirty article in solvent in the tank. If there is more than one solvent cleaning tank, the second tank can be another immersion tank orit can be designed for vapour contact and for recovery of condensed solvent off the article.

The azeotroping tank preferably has a reservoir at its base for containing aqueous medium and a heater for heating the aqueous medium. The condenser across the outlet (often an open top) of the steaming tank may be a cool heat exchanger, for instance cooled by cold water, equipped with means for collecting condensate that condenses on to its outer surfaces. The condenser should be constructed so as essentially to prevent the escape from the tank of any solvent. The condensate will consist of the solvent and generally some water and preferably this is subjected to phase separation with the solvent being recycled to the, or one of the solvent cleaning tanks and with the water either being run to waste or recycled to the steaming tank.

Although it is adequate for the apparatus to consist solely of a liquid solvent tank and a steaming tank, particularly good results can be achieved when the apparatus consists of a liquid solvent tank, a second solvent cleaning tank in which the articles are contacted with vaporised solvent in the presence of steam, and the steaming tank. The inclusion of water with the solvent vapour reduces flammability and so makes safer the vapour cleaning of the articles. The mixed condensate of solvent and water can be recycled to the reservoir of this intermediate tank without phase separation, although usually phase separation is performed so as to facilitate control of the proportions of solvent and water in the reservoir.

A particularly valuable feature of the invention is that the apparatus in which it is performed can be substantially identical to existing ultrasonic cleaning apparatus for use with fluorocarbons and other halogenated, highly volatile, solvents. The only modification that has to be made is that aqueous medium is fed to the final tank in place of the fluorocarbon that previously was fed to that tank for evaporation, the heater in that tank has to have the required heat output and the temperature in the condenser has to be adjusted to condense the solvent and water. When the conventional tank has two vapour phase stages after a liquid immersion tank, it will be necessary to provide means for supplying water also to the reservoir in the second stage.

Contact of the articles with the terpene or other solvent can be vapour contact provided the vessel contains sufficient of an inert gas (for instance carbon dioxide, nitrogen, steam or other oxygen-free gas) to raise the flash point adequately, or the solvent itself has a sufficiently high flash point to cause no flash danger. Generally however contact is by immersion in liquid solvent at a temperature that preferably is well below the flash point, for instance at least 10°C and often at least 20°C below the flash point of the solvent. The effectiveness of contact can be promoted by mechanical or, preferably, ultrasonic agitation of the solvent.

The azeotroping is preferably conducted at a temperature of below 100°C. The surface from which azeotropic evaporation is to occur should preferably have an elevated temperature. The article may have been preheated (either in the solvent treatment stages or previously) but often the article is heated to the desired azeotroping temperature by contact with the aqueous medium at an elevated temperature. The temperature of the surface is at least 60°C, usually at least 80°C and preferably at least 95°C. Best results are achieved if the temperature is 98 or, preferably, 100°C. The use of such temperatures facilitates removal of final residues of aqueous medium. Indeed it can be desirable to continue contact with hot aqueous medium after substantially all the azeotroping has been completed, primarily to raise the surface to a sufficiently high high temperature as to promote final evaporation of residues of aqueous medium.

A preferred way of performing the contact with the aqueous medium is to contact the contaminated surface with the aqueous medium at a temperature of at least about 98°C. Preferably therefore the aqueous medium is applied as steam, and this steam can either consist substantially only of water vapour or it can comprise water vapour and a spray of water very near to its boiling point. Thus a boiling water spray (i.e., wet steam) is particularly preferred.

Best results are generally obtained when the azeotropic evaporation of the solvent contamination is conducted while the article is exposed to a gaseous atmosphere. Often therefore the article is held in a stream of steam, and in particular by holding the article above a reservoir containing boiling water or other aqueous medium.

However another method that can be conducted is to immerse the article in hot aqueous medium and then to lift the article out of the medium and allow azeotroping to occur off the surface of the article, due to the elevated temperature of the surface. For instance the aqueous medium can have a temperature of from 60 to 99°C and the temperature must be such, having regard to the components in the aqueous medium and the solvent, that azeotroping will occur off the surface when the article is lifted out of the aqueous medium.

In another method, the article (preferably pre-heated) is immersed in liquid aqueous medium and azeotropic evaporation of the solvent and water (and optionally tertiary solvent) is conducted while the article remains immersed in the liquid.

An advantage of the presence of the aqueous medium, and in particular of processes in which the atmosphere above the aqueous medium is saturated by steam, is that this raises the flash point of the solvent in the ambient atmosphere. In the absence of the steam the solvent would frequently be above its flash point and so simple heating at the temperature of the steaming would be dangerous. However the presence of the steam reduces fire hazard since it concludes oxygen and renders the process safer. An additional purpose that sometimes applies, especially when the steaming includes use of a spray of water very near to its boiling point, is that steam that condenses on to the article will wash off the article water-soluble residues that may not have been removed by the contact with solvent, examples being inorganic salts.

The safety of the process, and the performance, can be improved further by including additional materials in the steam atmosphere either to promote volatilisation of the solvent or to raise the flash point of the combined vapours or both. For instance the flash point of the vapours will be raised if the steaming is conducted in the presence of an inert gas, such as carbon dioxide or nitrogen.

The process of the invention can be applied to the treatment of soft surfaces such as fabrics and other fibrous materials, but preferably is applied to the treatment of hard surfaces such as glass, ceramics and metal. The articles having these surfaces can be, for instance, machined metal parts or, preferably, printed circuit boards. The articles are held in the solvent cleaning tank and the subsequent tank in or on suitable containers, for instance by being suspended from a holder or by being supported in or on a holder, for instance a tray.

The following are examples of the invention.

### Example 1

This process is conducted in a conventional ultrasonic cleaning apparatus designed for use with fluorocarbons. The apparatus consists of three adjacent tanks. The first tank is constructed to be substantially filled with liquid solvent. The second and third tanks are connected and each have a bottom reservoir provided with a heater for evaporating liquid in the reservoir, so that the articles being cleaned can be subjected to vapour contact with the solvent and solvent can condense on the articles and drain back into the reservoir. All the tanks are open at the top, so as to facilitate the articles being lowered into and drawn up from the liquid or vapour phase. Chilled condenser tubes surround the open outlets of the second and third tanks.

In the invention, the solvent is mainly para-menthenes with para-cymene having a distillation range typically somewhere in the range 150 to 200°C and that optionally includes a small amount of isopropanol as a surface tension modifier.

A tray of metal parts or circuit boards is immersed in the solvent at 35°C for 60 seconds with ultrasonic agitation or sub-surface circulation. The tray is removed from the immersion tank and allowed to drain into the second tank, the reservoir of which contains water (and some solvent) at 99°C. At this temperature the water and solvent azeotropes and the vapour condenses on to the articles and drains back into the reservoir. Carbon dioxide is blown into this tank so as to raise the flash point additionally.

The articles are then transferred to the third tank, the reservoir of which again contains water heated to a temperature sufficient to cause distillation. The heating is preferably conducted for sufficient time for the temperature to reach 100°C, and again carbon dioxide is preferably blown into the tank. Upon removal from this third tank, the articles are free of solvent and water.

Water and solvent are collected from the condensers to the second and third tanks and subjected to phase separation, the solvent being returned to the immersion tank and the water to the final steaming tank.

### Example 2

In another example, the second tank can be omitted in which event the solvent is preferably drained from the articles into the immersion tank before being transferred to the steaming tank.

### Description of the drawings

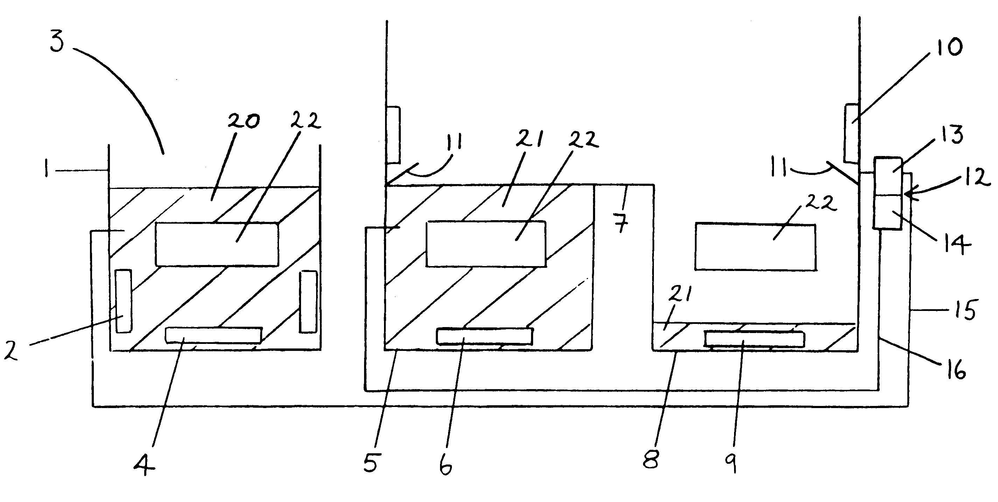

Apparatus suitable for use in the process of, for instance, Example 1 is illustrated schematically in the accompanying drawing. It comprises a tank 1 filled with solvent 20 the level shown and provided with ultrasonic generator 2 and an open top 3 for the introduction of articels 22 to be cleaned and a heater 4.
a second tank 5 is equipped with a heater 6 and is connected by a weir 7 to a third tank 8 having a heater 9. Tank 5 is filled, to the level shown, with water 21 in its bases that is boiled by heater 9 to generate steam. The combined tanks 5,8, are open to permit articles 22 to be immersed in the hot water in tank 5 and then in the steam in tank 8.

A condenser 10 extends around the open tanks 5, 8 to collect azeotrope condensate in trough 11. This leads to a vessel 12 in which the condensate separates into an aqueous phase 14 that is recycled by line 16 to tank 5, and a solvent phase 12 that is recycled tank 1 by line 15.

Means (not shown) are provided for moving the articles 22 in sequence through the tanks.

## Claims

1. A process for cleaning a dirty article, comprising:
(a) contacting said dirty article with a solvent comprising a hydrogenated or dehydrogenated analogue of terpene under conditions resulting in cleaning of dirt from said dirty article,
wherein said analogue-cleaned article is contaminated with a residue of said analogue remaining on the surface of said analogue-cleaned article; and
(b) evaporating the residue from the surface by contacting said analogue-contaminated article with an aqueous medium at a temperature of at least 60°C to produce a distillate comprising solvent and aqueous medium.

2. A process according to claim 1, wherein the solvent and aqueous medium form an azeotrope.

3. The process of any preceding claim wherein the temperature of the aqueous medium is from about 80-100°C.

4. The process of any preceding claim wherein said aqueous medium has a temperature of at least 98°C.

5. The process of any preceding claim wherein said evaporation step (b) is conducted in a gaseous atmosphere comprising steam.

6. The process of claim 1 wherein said aqueous medium is a liquid having a temperature of from about 60-99°C, and wherein said evaporating step (b) comprises immersing said analogue-contaminated article in said liquid aqueous medium for a time sufficient to elevate the temperature of the surface of the article and then removing the article from said medium, whereby solvent and aqueous medium evaporate from the surface of the article.

7. The process of any preceding claim wherein said analogue is selected from the group consisting of cymenes, menthenes and menthanes.

8. The process of claim 7 wherein said solvent contains at least 50% by weight of cymene, menthene, menthane or mixtures thereof.

9. The process of any preceding claim wherein said solvent further comprises a tertiary solvent said tertiary solvent having a boiling point below 100°C.

10. The process of claim 9 wherein said solvent contains less than 10% by weight of said tertiary solvent.

11. The process of any of claims 1 to 8 wherein said aqueous medium further comprises a tertiary solvent said tertiary solvent having a boiling point below 100°C.

12. The process of claim 11 wherein the ratio of said tertiary solvent to water is from about 1:50 to about 10:1.

13. The process of any of claims 9 to 12 wherein said tertiary solvent is an aliphatic compound having from 2 to 8 carbon atoms and is selected from the group consisting of ketones, amines, ethers and alcohols.

14. The process of claim 13 wherein said tertiary solvent is selected from the group consisting of isobutanol and isopropanol.

15. The process of any of claims 1 to 14 wherein said solvent further comprises a surfactant.

16. The process of claim 15 wherein said solvent contains less than 10% by weight of said surfactant.

17. The process of any preceding claim wherein said aqueous medium further comprises a surfactant.

18. The process of any preceding claim further comprising: recovering said distillate, by condensation, separating said solvent from said aqueous medium in the distillate; and recycling said separated solvent for use in said contacting step (a).

19. The process of claim 18 further comprising recycling said recovered aqueous medium for use in said evaporating step (b).

20. The process of any preceding claim wherein said contacting step (a) comprises contacting said article sequentially with said solvent in liquid form and then with said solvent in vapour form in the presence of steam.

## Patentansprüche

1. Verfahren zur Reinigung eines schmutzigen Gegenstandes, umfassend:
(a) Kontaktieren des schmutzigen Gegenstandes mit einem ein hydriertes oder dehydriertes Terpen-Analogon umfassenden Lösungsmittel unter Bedingungen, die zu einer Reinigung des schmutzigen Gegenstandes von Schmutz führen, worin der mit dem Analogon gereinigte Gegenstand mit einem Rückstand des Analogons verunreinigt ist, der auf der Oberfläche des mit dem Analogon gereinigten Gegenstandes verbleibt; und
(b) Abdampfen des Rückstandes von der Oberfläche durch Kontaktieren des mit dem Analogon verunreinigten Gegenstandes mit einem wäßrigen Medium bei einer Temperatur von mindestens 60°C, um ein Destillat herzustellen, das Lösungsmittel und wäßriges Medium umfaßt.

2. Verfahren nach Anspruch 1, worin das Lösungsmittel und das wäßrige Medium ein Azeotrop bilden.

3. Verfahren nach irgendeinem vorangehenden Anspruch, worin die Temperatur des wäßrigen Mediums etwa 80-100°C beträgt.

4. Verfahren nach irgendeinem vorangehenden Anspruch, worin das wäßrige Medium eine Temperatur von mindestens 98°C hat.

5. Verfahren nach irgendeinem vorangehenden Anspruch, worin der Abdampfungsschritt (b) in einer Wasserdampf umfassenden Gasatmosphäre erfolgt.

6. Verfahren nach Anspruch 1, worin das wäßrige Medium eine Flüssigkeit mit einer Temperatur von etwa 60-99°C ist und worin der Abdampfungsschritt (b) das Eintauchen des mit dem Analogon verunreinigten Gegenstandes in das flüssige wäßrige Medium über einen Zeitraum hinweg, der ausreicht, um die Temperatur der Oberfläche des Gegenstandes zu erhöhen, und das anschließende Entnehmen des Gegenstandes aus dem Medium, wodurch Lösungsmittel und wäßriges Medium von der Oberfläche des Gegenstandes abdampfen, umfaßt.

7. Verfahren nach irgendeinem vorangehenden Anspruch, worin das Analogon ausgewählt ist aus der Gruppe, die besteht aus Cymenen, Menthenen und Menthanen.

8. Verfahren nach Anspruch 7, worin das Lösungsmittel mindestens 50 Gew.-% Cymen, Menthen, Menthan oder Mischungen davon enthält.

9. Verfahren nach irgendeinem vorangehenden Anspruch, worin das Lösungsmittel weiter ein tertiäres Lösungsmittel umfaßt, wobei das tertiäre Lösungsmittel einen Siedepunkt unter 100°C hat.

10. Verfahren nach Anspruch 9, worin das Lösungsmittel weniger als 10 Gew.-% des tertiären Lösungsmittels enthält.

11. Verfahren nach irgendeinem der Ansprüche 1 bis 8, worin das wäßrige Medium weiter ein tertiäres Lösungsmittel umfaßt, wobei das tertiäre Lösungsmittel einen Siedepunkt unter 100°C hat.

12. Verfahren nach Anspruch 11, worin das Verhältnis des tertiären Lösungsmittels zu Wasser etwa 1:50 bis etwa 10:1 beträgt.

13. Verfahren nach irgendeinem der Ansprüche 9 bis 12, worin das tertiäre Lösungsmittel eine aliphatische Verbindung mit 2 bis 8 Kohlenstoffatomen ist und ausgewählt ist aus der Gruppe, die besteht aus Ketonen, Aminen, Ethern und Alkoholen.

14. Verfahren nach Anspruch 13, worin das tertiäre Lösungsmittel ausgewählt ist aus der Gruppe, die besteht aus Isobutanol und Isopropanol.

15. Verfahren nach irgendeinem der Ansprüche 1 bis 14, worin das Lösungsmittel weiter ein Tensid umfaßt.

16. Verfahren nach Anspruch 15, worin das Lösungsmittel weniger als 10 Gew.-% des Tensids enthält.

17. Verfahren nach irgendeinem vorangehenden Anspruch, worin das wäßrige Medium weiter ein Tensid umfaßt.

18. Verfahren nach irgendeinem vorangehenden Anspruch, weiter umfassend:
Gewinnung des Destillats durch Kondensation, Abtrennen des Lösungsmittels von dem wäßrigen Medium in dem Destillat; und Rückführen des abgetrennten Lösungsmittels zur Verwendung in dem Kontaktierschritt (a).

19. Verfahren nach Anspruch 18, weiter umfassend das Rückführen des gewonnenen wäßrigen Mediums zur Verwendung in dem Andampfungsschritt (b).

20. Verfahren nach irgendeinem vorangehenden Anspruch, worin der Kontaktierschritt (a) das aufeinanderfolgende Kontaktieren des Gegenstandes mit dem Lösungsmittel in flüssiger Form und dann mit dem Lösungsmittel in Dampfform in Gegenwart von Wasserdampf umfaßt.

## Revendications

1. Procédé pour nettoyer un article sale consistant :
(a) à mettre en contact ledit article sale avec un solvant comprenant un produit analogue du terpène hydrogéné ou déshydrogéné dans des conditions résultant en un nettoyage de la saleté dudit article sale,
dans lequel ledit article nettoyé par la produit analogue est pollué avec un résidu dudit produit analogue restant sur la surface dudit article nettoyé par le produit analogue ; et
(b) à faire évaporer le résidu de la surface en mettant en contact ledit article pollué par le produit analogue avec un milieu aqueux à une température d'au moins 60°C pour produire un distillat comprenant le solvant et le milieu aqueux.

2. Procédé selon la revendication 1, dans lequel le solvant et le milieu aqueux forment un azéotrope.

3. Procédé selon l'une quelconque des revendications précédentes, dans lequel la température du milieu aqueux est d'environ 80-100°C.

4. Procédé selon l'une quelconque des revendications précédentes, dans lequel ledit milieu aqueux présente une température d'au moins 98°C.

5. Procédé selon l'une quelconque des revendications précédentes, dans lequel ladite étape d'évaporation (b) est réalisée dans une atmosphère gazeuse comprenant de la vapeur d'eau.

6. Procédé selon la revendication 1, dans lequel ledit milieu aqueux est un liquide présentant une température d'environ 60-99°C et dans lequel ladite étape d'évaporation (b) consiste à immerger ledit article pollué par le produit analogue dans ledit milieu liquide aqueux pendant une durée suffisante pour élever la température de la surface de l'article et à retirer ensuite l'article dudit milieu, sur quoi le solvant et le milieu aqueux s'évaporent de la surface de l'article.

7. Procédé selon l'une quelconque des revendications précédentes, dans lequel ledit produit analogue est choisi dans le groupe constitué des cymènes, des menthènes et des menthanes.

8. Procédé selon la revendication 7, dans lequel ledit solvant contient au moins 50 % en poids de cymène, de menthène, de menthane ou de mélanges de ceux-ci.

9. Procédé selon l'une quelconque des revendications précédentes, dans lequel ledit solvant comprend en outre un troisième solvant, ledit troisième solvant ayant un point d'ébullition inférieur à 100°C.

10. Procédé selon la revendication 9, dans lequel ledit solvant contient moins de 10 % en poids dudit troisième solvant.

11. Procédé selon l'une quelconque des revendications 1 à 8, dans lequel ledit milieu aqueux comprend en outre un troisième solvant, ledit troisième solvant ayant un point d'ébullition inférieur à 100°C.

12. Procédé selon la revendication 11, dans lequel le rapport dudit troisième solvant à l'eau est compris entre environ 1:50 et environ 10:1.

13. Procédé selon l'une quelconque des revendications 9 à 12, dans lequel ledit troisième solvant est un composé aliphatique présentant de 2 à 8 atomes de carbone et est choisi dans le groupe constitué des cétones, des amines, des éthers et des alcools.

14. Procédé selon la revendication 13, dans lequel ledit troisième solvant est choisi dans le groupe constitué d'isobutanol et d'isopropanol.

15. Procédé selon l'une quelconque des revendications 1 à 14, dans lequel ledit solvant comprend en outre un tensioactif.

16. Procédé selon la revendication 15, dans lequel ledit solvant contient moins de 10 % en poids dudit tensioactif.

17. Procédé selon l'une quelconque des revendications précédentes, dans lequel ledit milieu aqueux comprend en outre un tensioactif.

18. Procédé selon l'une quelconque des revendications précédentes consistant en outre : à récupérer ledit distillat par condensation, à séparer ledit solvant dudit milieu aqueux dans le distillat ; et à recycler ledit solvant séparé pour une utilisation dans ladite étape de mise en contact (a).

19. Procédé selon la revendication 18 consistant en outre à recycler ledit milieu aqueux récupéré pour une utilisation dans ladite étape d'évaporation (b).

20. Procédé selon l'une quelconque des revendications précédentes, dans lequel ladite étape de mise en contact (a) consiste à mettre en contact successivement ledit article avec ledit solvant dans une forme liquide et ensuite avec ledit solvant dans une forme vapeur en présence de vapeur d'eau.
